# DEMANDE DE BREVET EUROPEEN

(11) **EP 4 492 070 A1**
(43) Date de publication de la demande: **15.01.2025**
(21) Numéro de dépôt: 24184185.7
(22) Date de dépôt: 25.06.2024
(51) Int. Cl.: G01R 31/08, G01R 31/12, G01R 31/58, H04Q 9/00

(54) **SYSTÈME DE SURVEILLANCE EN LIGNE D'UN OU PLUSIEURS CÂBLES ÉLECTRIQUES DANS UN RÉSEAU DE DISTRIBUTION ÉLECTRIQUE**

(30) Priorité: 04.07.2023 FR 2307089
(71) Demandeur: Nexans, 92400 Courbevoie (FR)
(72) Inventeur: KAFAL, Moussa, 91940 LES ULIS (FR); GRIOT, Samuel, 69007 LYON (FR); ANDRE, Aymeric, 69002 LYON (FR); PINTO, Olivier, 69340 FRANCHEVILLE (FR)
(74) Mandataire: Ipsilon

(57) **Abrégé**

L'invention concerne un système de surveillance en ligne d'un ensemble de câbles électriques (1) reliés en série dans un réseau de distribution électrique, comportant une unité centrale (2) localisée sur une portion dudit ensemble et des unités d'acquisition de données (3ₐ, 3_{b}, 3_{c}) réparties le long des câbles (1) à des positions prédéfinies. Le système comporte des sous-ensembles de capteurs de mesure (4ₐ₋₁-4ₐ₋₂, 4_{b-1}-4_{b-4}, 4_{c-1}), les capteurs d'un sous-ensemble étant associés à une même unité d'acquisition et répartis sur une portion desdits câbles au voisinage de ladite unité d'acquisition, le nombre et le type de capteurs d'un sous-ensemble variant selon la position de l'unité d'acquisition à laquelle ces capteurs sont associés et la taille de ladite portion. Chaque unité d'acquisition est configurée pour recevoir et prétraiter, sous la commande de l'unité centrale, des mesures provenant des capteurs qui lui sont associés, et pour transmettre les mesures prétraitées à l'unité centrale.

## Description

### Domaine technique

La présente invention concerne le domaine général de la surveillance du bon fonctionnement des éléments présents dans un réseau de distribution électrique, notamment des câbles électriques, et plus précisément un système de surveillance en ligne d'un ensemble comportant un ou plusieurs câbles électriques reliés en série dans un réseau de distribution électrique.

### Arrière-plan technologique

L'augmentation de la demande d'électricité, due à la fois à la croissance démographique, au développement économique et à l'évolution des modes de consommation, nécessite des investissements croissants dans les réseaux de distribution d'électricité. Dans ces réseaux, chaque fraction temporelle d'énergie non distribuée représente un facteur de perte financière. La distribution d'électricité est également le marché qui connaît le plus grand nombre de défaillances pour diverses raisons (étendue géographique, diversité des technologies, installation réalisée par des tiers, etc.)

Les câbles électriques à moyenne tension (MT) font partie intégrante du réseau de distribution d'électricité qui couvre de vastes zones et fournit de grandes quantités d'énergie. La part des câbles électriques MT souterrains augmente considérablement en raison notamment de leur fiabilité, de leur sécurité, de leur durée de vie plus longue, etc. Le fonctionnement ininterrompu des réseaux MT souterrains est donc d'une importance cruciale pour la fiabilité globale du système. Néanmoins, l'accès à ces câbles n'est pas facile et s'accompagne d'un coût élevé, d'autant plus que la connectivité cellulaire locale impossible, sauf aux extrémités des câbles ou en de rares occasions (puits de jonction...).

Les câbles électriques doivent pouvoir transmettre autant d'énergie que possible pour répondre aux demandes fluctuantes des différents marchés et environnements - en particulier maintenant que les besoins de transport d'énergie évoluent grâce au déploiement accru de nouvelles utilisations du réseau, qui ne se limitent pas aux injections de ressources énergétiques renouvelables (RER), aux véhicules électriques (VE), etc. Ce dernier phénomène peut réduire les marges techniques et, dans certains cas, faire fonctionner les câbles de manière dynamique en fonction du goulot d'étranglement le plus défavorable en termes de température maximale (point chaud).

D'autre part, le changement climatique s'est récemment accompagné de conditions environnementales défavorables plus intenses et plus graves (vagues de chaleur, inondations, etc.), ce qui a entraîné des niveaux de stress sans précédent sur le réseau électrique, accompagnés d'une augmentation des défaillances et d'une accélération du rythme de vieillissement. Cela a mis en lumière l'importance accrue de la résilience des réseaux électriques. Le sujet devient de plus en plus pressant car il garantit un approvisionnement fiable en électricité, essentiel pour soutenir l'activité économique, et protège la sécurité publique, en particulier en temps de crise.

Il est tout d'abord essentiel de tout mettre en oeuvre pour prévenir des défaillances de câbles, car elles peuvent être très coûteuses, non seulement en termes de frais de réparation, mais aussi en termes de perte de revenus et d'impact sur l'image de marque des distributeurs d'énergie. En cas de défaillance, il est également essentiel de localiser cette défaillance et d'y remédier le plus rapidement possible sans avoir à fermer les réseaux, ce qui entraînerait une interruption de l'alimentation électrique et des pertes. Par conséquent, les systèmes de surveillance en ligne non intrusifs sont essentiels pour éviter l'apparition de tels problèmes.

La température, les profils mécaniques, acoustiques et électriques d'un réseau de distribution électrique MT sont autant de paramètres importants qui peuvent être surveillés pour permettre une inspection et une analyse approfondies des risques potentiels susceptibles d'affecter un câble, un accessoire, etc.

Par exemple, un câble électrique transportant un courant élevé ou fonctionnant à une température élevée (vagues de chaleur, sol sec, etc.) risque de subir une contrainte thermique diélectrique, qui peut entraîner une défaillance de l'isolation. En surveillant la température du câble, il est possible de détecter le moment où le câble s'approche de sa température maximale et de prendre les mesures nécessaires pour éviter la défaillance.

D'autre part, les signaux acoustiques dans les câbles électriques sont accompagnés d'une variété de facteurs, tels qu'une décharge électrique, une contrainte mécanique ou des changements de température, etc. La surveillance continue des signaux acoustiques permet de détecter ces événements et d'utiliser les informations pour identifier les problèmes potentiels du câble.

En outre, les mesures de déformation ou d'étirement d'un câble permettent de quantifier les forces externes subies par le câble, telles que les contraintes mécaniques ou les changements de température. Ainsi, en surveillant en permanence la déformation d'un câble d'alimentation, il est possible de détecter des changements dans l'état et les performances du câble, ainsi que les forces qui agissent sur lui.

Enfin, des événements précurseurs de défauts (décharges partielles, frottement, etc.) dans les réseaux électriques sont généralement accompagnés de signaux transitoires à haute fréquence qui se propagent le long du réseau, grâce au câble lui-même qui agit comme un canal de propagation. La surveillance de ces impulsions permet de détecter et de localiser les points faibles potentiels et fournit donc une approche d'alerte précoce.

A ce jour, on connaît déjà un système de détection distribué par fibre optique capable d'implémenter simultanément, au niveau d'un câble à surveiller intégrant une fibre optique, des solutions de détection de la température distribuée (DTS), de détection acoustique distribuée (DAS), et de détection de déformation distribuée (DSS). Ce type de système utilise un câble à fibre optique intégré au câble électrique à surveiller et recouvert de matériaux sensibles à la température, à la déformation et à l'acoustique. En mesurant les variations d'intensité de la lumière transmise par le câble à fibres optiques, il est possible de déterminer la température, la déformation et les signaux acoustiques sur toute la longueur du câble. Alors qu'il est courant que les câbles à haute tension soient équipés de fibres optiques, les câbles à basse ou moyenne tension souterrains sont moins susceptibles d'en être équipés, la décision de les inclure dépendant des exigences spécifiques de l'application (transmission de données, etc.), de la complexité et des préoccupations relatives aux coûts de remplacement. En outre, de tels systèmes à fibres optiques ne permettent pas de mesurer les décharges partielles.

Par ailleurs, le document US 2015/69998 décrit un système de surveillance en ligne d'un ensemble comportant des câbles électriques reliés en série dans un réseau de distribution électrique, le système comportant une pluralité d'unités d'acquisition de données identiques réparties le long des câbles électriques à des positions prédéfinies, et aptes à communiquer des données entre elles. Chaque unité d'acquisition de données est constituée d'un boîtier qui peut être fixé le long des câbles électriques, ce boîtier intégrant une pluralité de capteurs de mesure aptes à mesurer, directement ou indirectement, différents paramètres, par exemple un capteur de mesure de courant, un capteur de mesure de courant de surtension, un capteur de mesure de courant de défaut, un capteur de mesure de champ électrique et un capteur de mesure de température de ligne. Un tel système ne permet ni d'anticiper des défaillances liées aux décharges partielles, ni de détecter les signaux acoustiques et/ou les déformations dans les câbles. En outre, un tel système ne permet pas de dériver un profil de température suffisamment précis, sauf à placer un très grand nombre de boîtiers à faible distance les uns par rapport aux autres le long des câbles, pour mesurer la température en suffisamment de points grâce au capteur de température intégré dans le boîtier.

### Résumé de l'invention

La présente invention a pour but de pallier les inconvénients des systèmes précités en proposant un système à moindre coût qui puisse faire le diagnostic de plusieurs types de défaillances dans un ensemble de câbles électriques reliés en série.

Plus précisément, la présente invention a pour objet un système de surveillance en ligne d'un ensemble comportant un ou plusieurs câbles électriques reliés en série dans un réseau de distribution électrique, le système comportant une unité centrale localisée sur une portion dudit ensemble sous surveillance et une pluralité d'unités d'acquisition de données réparties le long dudit un ou plusieurs câbles électriques à des positions prédéfinies, et étant caractérisé en ce qu'il comporte en outre une pluralité de sous-ensembles de capteurs de mesure, les capteurs de mesure d'un sous-ensemble donné étant associés à une même et unique unité d'acquisition de données et répartis sur au moins une portion de longueur dudit un ou plusieurs câbles électriques au voisinage de ladite même et unique unité d'acquisition de données, en ce que le nombre et le type de capteurs de mesure d'un sous-ensemble donné varient selon la position de l'unité d'acquisition de données à laquelle ces capteurs de mesure sont associés et la taille de ladite portion de longueur, et en ce que chaque unité d'acquisition de données est configurée pour recevoir et prétraiter, lors de campagnes d'acquisition réalisées sous la commande de l'unité centrale, des mesures provenant des capteurs de mesure qui lui sont associés dans un sous-ensemble donné, et pour transmettre les mesures reçues et prétraitées à l'unité centrale.

Dans un mode de réalisation possible, au moins un sous-ensemble de capteurs de mesure comporte une pluralité de capteurs de mesure de même nature répartis sur ladite portion de longueur.

Dans un mode de réalisation possible, au moins un sous-ensemble de capteurs de mesure comporte deux ou plusieurs capteurs de température et/ou deux ou plusieurs capteurs de signaux acoustiques répartis sur ladite portion de longueur.

Dans un mode de réalisation possible, au moins deux sous-ensembles de capteurs de mesure comportent un capteur inductif configuré pour détecter des événements impulsionnels occasionnés par des décharges partielles.

Dans un mode de réalisation possible, les capteurs de mesure d'un sous-ensemble donné transmettent leurs mesures à l'unité d'acquisition de données qui leur est associée par un lien de communication filaire ou sans fil.

Chaque unité d'acquisition de données peut être avantageusement configurée pour transmettre les mesures reçues et prétraitées à l'unité centrale via ledit un ou plusieurs câbles électriques.

Le système peut comporter en outre une unité distante avec laquelle l'unité centrale échange des données via un réseau Internet, l'unité centrale étant configurée pour transmettre des données basées sur une agrégation des mesures reçues et prétraitées.

L'unité centrale est localisée par exemple sur une portion d'extrémité dudit ensemble sous surveillance.

Dans un mode de réalisation possible, deux unités d'acquisition de données consécutives sont séparées d'une distance de l'ordre du kilomètre, et la taille de ladite portion de longueur est comprise entre 50 et 500 mètres.

### Brève description des figures

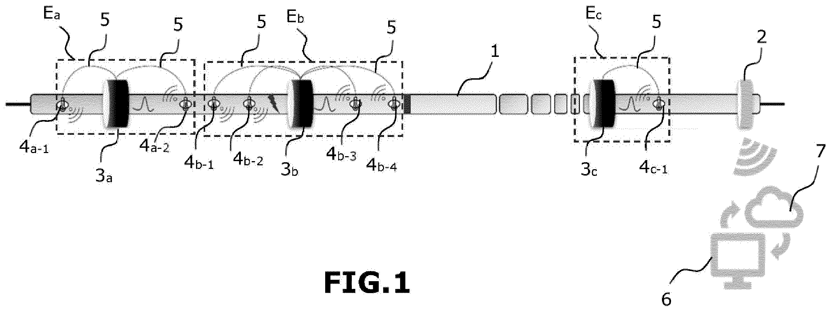

La description qui va suivre en regard du dessin annexé, donné à titre d'exemple non limitatif, fera bien comprendre en quoi consiste l'invention et comment elle peut être réalisée. La figure 1 illustre un ensemble comportant un ou plusieurs câbles électriques 1 et un système de surveillance en ligne de cet ensemble conformément à l'invention.

### Description de mode(s) de réalisation

La figure 1 illustre partiellement et schématiquement un ensemble comportant un ou plusieurs câbles électriques 1 reliés en série dans un réseau de distribution électrique, et un système de surveillance en ligne de cet ensemble conformément à l'invention. Le réseau de distribution électrique est par exemple un réseau haute tension ou moyenne tension, composé d'une pluralité de câbles électriques tels que le câble électrique 1, d'accessoires de connexion ou de raccordement, d'appareillages et/ou de transformateurs.

Le système comporte une unité centrale 2 localisée sur une portion dudit ensemble sous surveillance. Dans le cas d'un réseau de distribution électrique souterrain, l'unité centrale 2 est de préférence située sur une portion d'extrémité de l'ensemble sous surveillance.

Le système comporte également une pluralité d'unités d'acquisition de données, telles que les trois unités d'acquisition de données 3ₐ, 3_{b} et 3_{c}, réparties le long dudit un ou plusieurs câbles électriques 1 à des positions prédéfinies. A titre d'exemple non limitatif, deux unités d'acquisition de données consécutives peuvent être séparées d'une distance de l'ordre du kilomètre.

Chaque unité d'acquisition de données peut être alimentée soit par une batterie, soit par un module intégré de collecte d'énergie à partir du courant circulant dans les câbles électriques. Le module de collecte d'énergie est particulièrement intéressant car il ne nécessite pas d'entretien de la batterie et permet d'éviter des travaux de génie civil coûteux pour accéder au câble. Ainsi, les unités d'acquisition peuvent être installée sur le câble, et le câble enterré sans autre maintenance planifiée.

Le système comporte en outre une pluralité de sous-ensembles de capteurs de mesure, tels que le premier sous-ensemble constitué des deux capteurs de mesure 4ₐ₋₁ et 4ₐ₋₂, le deuxième sous-ensemble constitué des quatre capteurs de mesure 4_{b-1} à 4_{b-4}, et le troisième sous-ensemble comportant le capteur de mesure 4_{c-1}.

Comme illustré sur la figure 1, les capteurs de mesure d'un sous-ensemble donné sont associés à une même et unique unité d'acquisition de données et répartis sur au moins une portion de longueur dudit un ou plusieurs câbles électriques 1 au voisinage de ladite même et unique unité d'acquisition de données. Ainsi notamment :
- le premier sous-ensemble constitué des deux capteurs de mesure 4ₐ₋₁ et 4ₐ₋₂ est associé à l'unité d'acquisition de données 3ₐ et forme avec cette unité un sous-système référencé Eₐ sur la figure ;
- le deuxième sous-ensemble constitué des quatre capteurs de mesure 4_{b-1} à 4_{b-4} est associé à l'unité d'acquisition de données 3_{b} et forme avec cette unité un sous-système référencé E_{b} sur la figure ; et
- te troisième sous-ensemble comportant le capteur de mesure 4_{c-1} est associé à l'unité d'acquisition de données 3_{c} et forme avec cette unité un sous-système référencé E_{c} sur la figure.

Chaque unité d'acquisition de données 3ₐ, 3_{b}, 3_{c} est configurée pour recevoir et prétraiter, lors de campagnes d'acquisition réalisées sous la commande de l'unité centrale 2, des mesures provenant des capteurs de mesure qui lui sont associés dans un sous-ensemble donné, et pour transmettre les mesures reçues et prétraitées à l'unité centrale 2. En d'autres termes, chaque sous-système, tel que les sous-systèmes Eₐ, E_{b} et E_{c} de la figure, est un sous-système esclave permettant d'acquérir les mesures des capteurs de mesures associés répartis sur la portion de longueur de câble correspondante, sur commande de l'unité maître 2.

Le nombre et le type de capteurs de mesure constituant chaque sous-ensemble varient selon la position de l'unité d'acquisition de données à laquelle ces capteurs de mesure sont associés et la taille de la portion de longueur associée au sous-ensemble. A titre d'exemple non limitatif, si les unités d'acquisition de données consécutives sont distantes, la taille de la portion de longueur associée à chaque sous-ensemble pourra être comprise entre 50 et 500 mètres.

Le système de surveillance offre donc une grande flexibilité puisqu'il est possible d'adapter la composition de chaque sous-ensemble de capteurs de mesure en fonction de l'architecture réelle du réseau de distribution sous surveillance. On peut par exemple choisir de placer des capteurs de signaux acoustiques dans des zones particulières du réseau, telles que les zones proches des accessoires ou des jonctions.

Dans un mode de réalisation possible du système selon l'invention, on peut prévoir qu'au moins un sous-ensemble de capteurs de mesure comporte une pluralité de capteurs de mesure de même nature répartis sur ladite portion de longueur.

On peut également prévoir un système dans lequel au moins un sous-ensemble de capteurs de mesure comporte deux ou plusieurs capteurs de température et/ou deux ou plusieurs capteurs de signaux acoustiques répartis sur ladite portion de longueur.

De manière préférée, tous les sous-ensembles de capteurs de mesure comprennent une pluralité de capteurs de température répartis sur leur portion de longueur respective. Cela permet d'avoir, à moindre coût, une grande quantité de points de mesure de la température le long des câbles. Par exemple, pour un ensemble de câbles de longueur de 10 km, on peut prévoir :
- de disposer une unité d'acquisition de données tous les kilomètres ; et
- que tous les sous-ensembles de capteurs comprennent des capteurs de mesure de température répartis tous les 5 à 10 mètres sur une portion de longueur comprise entre 50 et 500 mètres d'un seul côté de l'unité d'acquisition, ou de 100 mètres à kilomètre de part et d'autre d'une unité d'acquisition.

Alternativement ou en combinaison, on peut également prévoir qu'au moins deux sous-ensembles de capteurs de mesure du système comportent un capteur inductif configuré pour détecter des événements impulsionnels occasionnés par des décharges partielles.

Dans tous les cas, les capteurs de mesure d'un sous-ensemble donné transmettent leurs mesures à l'unité d'acquisition de données qui leur est associée par un lien de communication filaire et/ou sans fil (par exemple selon le protocole WiFi ou Bluetooth).

Dans un mode de réalisation possible du système de surveillance selon l'invention, chaque unité d'acquisition de données 3ₐ, 3_{b}, 3_{c} est configurée pour transmettre les mesures reçues et prétraitées à l'unité centrale 2 via ledit un ou plusieurs câbles électriques 1.

Comme illustré dans l'exemple non limitatif de la figure, le système comporte également une unité distante 6 avec laquelle l'unité centrale 2 échange des données via un réseau Internet 7. Dans ce cas, l'unité centrale 2 transmet à l'unité distante 6 des données basées sur une agrégation des mesures reçues et prétraitées.

## Revendications

1. Système de surveillance en ligne d'un ensemble comportant un ou plusieurs câbles électriques (1) reliés en série dans un réseau de distribution électrique, le système comportant une unité centrale (2) localisée sur une portion dudit ensemble sous surveillance et une pluralité d'unités d'acquisition de données (3ₐ, 3_{b}, 3_{c}) réparties le long dudit un ou plusieurs câbles électriques (1) à des positions prédéfinies, et étant **caractérisé en ce qu'**il comporte en outre une pluralité de sous-ensembles de capteurs de mesure (4ₐ₋₁-4ₐ₋₂, 4_{b-1}-4_{b-4}, 4_{c-1}), les capteurs de mesure d'un sous-ensemble donné étant associés à une même et unique unité d'acquisition de données et répartis sur au moins une portion de longueur dudit un ou plusieurs câbles électriques (1) au voisinage de ladite même et unique unité d'acquisition de données, **en ce que** le nombre et le type de capteurs de mesure d'un sous-ensemble donné varient selon la position de l'unité d'acquisition de données à laquelle ces capteurs de mesure sont associés et la taille de ladite portion de longueur, et **en ce que** chaque unité d'acquisition de données (3ₐ, 3_{b}, 3_{c}) est configurée pour recevoir et prétraiter, lors de campagnes d'acquisition réalisées sous la commande de l'unité centrale (2), des mesures provenant des capteurs de mesure qui lui sont associés dans un sous-ensemble donné, et pour transmettre les mesures reçues et prétraitées à l'unité centrale (2).

2. Système de surveillance selon la revendication 1, dans lequel au moins un sous-ensemble de capteurs de mesure comporte une pluralité de capteurs de mesure de même nature répartis sur ladite portion de longueur.

3. Système de surveillance selon l'une quelconque des revendications précédentes, dans lequel au moins un sous-ensemble de capteurs de mesure comporte deux ou plusieurs capteurs de température et/ou deux ou plusieurs capteurs de signaux acoustiques répartis sur ladite portion de longueur.

4. Système de surveillance selon l'une quelconque des revendications précédentes, dans lequel au moins deux sous-ensembles de capteurs de mesure comportent un capteur inductif configuré pour détecter des événements impulsionnels occasionnés par des décharges partielles.

5. Système de surveillance selon l'une quelconque des revendications précédentes, dans lequel les capteurs de mesure d'un sous-ensemble donné transmettent leurs mesures à l'unité d'acquisition de données qui leur est associée par un lien de communication filaire ou sans fil.

6. Système de surveillance selon l'une quelconque des revendications précédentes, dans lequel chaque unité d'acquisition de données (3ₐ, 3_{b}, 3_{c}) est configurée pour transmettre les mesures reçues et prétraitées à l'unité centrale (2) via ledit un ou plusieurs câbles électriques (1).

7. Système de surveillance selon l'une quelconque des revendications précédentes, comportant en outre une unité distante (6) avec laquelle l'unité centrale (2) échange des données via un réseau Internet (7), l'unité centrale (2) étant configurée pour transmettre des données basées sur une agrégation des mesures reçues et prétraitées.

8. Système de surveillance selon l'une quelconque des revendications précédentes, dans lequel l'unité centrale (2) est localisée sur une portion d'extrémité dudit ensemble sous surveillance.

9. Système de surveillance selon l'une quelconque des revendications précédentes, dans lequel deux unités d'acquisition de données consécutives sont séparées d'une distance de l'ordre du kilomètre, et la taille de ladite portion de longueur est comprise entre 50 et 500 mètres.
